# DEMANDE DE BREVET EUROPEEN

(11) **EP 4 521 887 A1**
(43) Date de publication de la demande: **12.03.2025**
(21) Numéro de dépôt: 24198341.0
(22) Date de dépôt: 04.09.2024
(51) Int. Cl.: H10F 71/00

(54) **PROCÉDÉ DE PASSIVATION DE CELLULES PHOTOVOLTAÏQUES**

(30) Priorité: 05.09.2023 FR 2309303
(71) Demandeur: Commissariat à l'Energie Atomique et aux Energies Alternatives, 75015 Paris (FR)
(72) Inventeur: HARRISON, Samuel, 38054 GRENOBLE CEDEX 09 (FR); ALBARIC, Mickaël, 38054 GRENOBLE CEDEX 09 (FR); MARTEL, Benoît, 38054 GRENOBLE CEDEX 09 (FR)
(74) Mandataire: Cabinet Camus Lebkiri

(57) **Abrégé**

L'invention concerne un procédé de passivation de cellules photovoltaïques (5) comprenant des étapes de :
- fourniture d'une pluralité de cellules photovoltaïques, chaque cellule (5) comprenant une face avant (5A), une face arrière (5B) et un bord périphérique (5C) reliant les faces avant et arrière,
- sur chaque cellule, formation d'un élément d'isolation (10) conformé selon le pourtour de la cellule, l'élément d'isolation étant formé sur la face avant ou arrière,
- empilement de la pluralité de cellules, l'élément d'isolation étant positionné entre deux cellules adjacentes de sorte que la face de la cellule munie de l'élément d'isolation soit positionnée à distance de la face en regard de la cellule adjacente, et
- dépôt d'une couche de passivation sur le bord périphérique des cellules par injection d'une espèce de passivation, l'élément d'isolation formant une barrière de pénétration à l'espèce de passivation de sorte que la couche de passivation recouvre le bord périphérique des cellules.

## Description

### DOMAINE TECHNIQUE

La présente invention concerne de manière générale la fabrication de cellules photovoltaïques.

L'invention concerne plus particulièrement un procédé de passivation de cellules photovoltaïques.

### ÉTAT DE LA TECHNIQUE

Un module photovoltaïque comprend une multitude de cellules photovoltaïques identiques connectées en série et/ou en parallèle afin de fournir en sortie la tension et/ou le courant requis pour alimenter des dispositifs électriques. Le format de module le plus courant emploie 60 cellules carrées (ou « pseudo-carrées »), de 156 mm de côté, réparties en six chaînes (« strings » en anglais) de dix cellules connectées en série. Les six chaînes de cellules photovoltaïques sont également connectées en série. La tension de circuit ouvert aux bornes du module est alors égale à 60 fois la tension de seuil d'une cellule photovoltaïque. Le courant électrique du module correspond approximativement au courant fourni par chaque cellule photovoltaïque (en pratique, les cellules photovoltaïques n'ont pas exactement les mêmes performances et le courant électrique est limité par la cellule la moins performante du module).

Avec les dernières technologies de cellules photovoltaïques, notamment la technologie PERT (pour « Passivated Emitter and Rear Totally diffused » en anglais), le courant d'une cellule monofaciale de 156 mm x 156 mm en superficie atteint des valeurs élevées, de l'ordre de 9 A pour une irradiance solaire de 1000 W/m². Ces valeurs de courant sont augmentées d'environ 20 % lorsqu'on utilise une cellule bifaciale, du fait du rayonnement solaire diffus capté en face arrière de la cellule. Ce fort courant électrique circule dans les éléments d'interconnexion entre les cellules du module et occasionne des pertes résistives importantes.

Afin de réduire ces pertes résistives, une solution consiste à assembler des modules avec des cellules photovoltaïques de superficie plus faible, et donc de courant plus faible. Ces cellules de plus faible superficie sont communément appelées « sous-cellules » et sont obtenues par découpage de cellules photovoltaïques de pleine taille (ex. 156 mm x 156 mm).

Cependant, le découpage d'une cellule photovoltaïque crée de nouveaux bords qui se retrouvent à nu. Par ailleurs, le découpage (au laser par exemple) est susceptible de créer des défauts et d'introduire des impuretés à proximité du plan de coupe. Ces défauts et impuretés diminuent la durée de vie des porteurs de charge libres en agissant comme centres de recombinaison des paires électron-trou, ce qui se traduit par une diminution du rendement de la cellule. Ce phénomène est particulièrement prononcé pour les cellules photovoltaïques à hétérojonction (HET), qui possèdent par nature très peu de défauts de surface et où la création de quelques défauts localisés suffit à réduire les performances électriques de la cellule de manière significative.

Il est notamment connu du document FR3091025 un procédé de passivation de cellules photovoltaïques permettant de localiser le dépôt d'un matériau de passivation au voisinage d'un bord seulement de la cellule photovoltaïque.

Pour être compatible avec les exigences d'une production industrielle, tout en déposant un matériau de passivation uniquement sur les bords des cellules photovoltaïques, le document FR3091025 décrit un agencement consistant à empiler une pluralité de cellules photovoltaïques les unes sur les autres, l'empilement reposant directement sur un support.

Selon cet agencement, les faces avant et arrière de chaque cellule photovoltaïque sont donc en contact direct avec l'une des faces d'une autre cellule photovoltaïque ou avec le support. Ce contact direct entraîne des risques de dégradations de ces faces avant et arrière, entraînant alors une dégradation des performances électriques (en particulier des modules photovoltaïques finaux comprenant ces cellules photovoltaïques).

### RÉSUMÉ DE L'INVENTION

La présente invention vise donc à améliorer la fabrication des cellules photovoltaïques en s'assurant notamment que le processus de passivation des cellules photovoltaïques ne dégrade pas les cellules photovoltaïques elles-mêmes ni les performances électriques associées, que les cellules photovoltaïques soient considérées indépendamment les unes des autres ou interconnectées dans un module photovoltaïque.

L'invention concerne alors tout d'abord un procédé de passivation de cellules photovoltaïques comprenant des étapes de :
- fourniture d'une pluralité de cellules photovoltaïques, chaque cellule photovoltaïque comprenant une face avant, destinée à être exposée à un rayonnement incident, une face arrière opposée à la face avant et un bord périphérique reliant la face avant et la face arrière,
- sur chaque cellule photovoltaïque de la pluralité de cellules photovoltaïques, formation d'un premier élément d'isolation conformé selon le pourtour de la cellule photovoltaïque concernée, le premier élément d'isolation étant formé sur la face avant ou sur la face arrière de la cellule photovoltaïque concernée,
- empilement de la pluralité de cellules photovoltaïques, le premier élément d'isolation de chaque cellule photovoltaïque étant positionné entre la cellule photovoltaïque concernée et une cellule photovoltaïque adjacente de telle manière que la face de la cellule photovoltaïque munie du premier élément d'isolation soit positionnée à distance de la face en regard de la cellule photovoltaïque adjacente, et
- dépôt d'une couche de passivation sur le bord périphérique des cellules photovoltaïques de la pluralité de cellules photovoltaïques par injection d'au moins une espèce de passivation, le premier élément d'isolation formant une barrière de pénétration à l'espèce de passivation de sorte que la couche de passivation recouvre le bord périphérique de chaque cellule photovoltaïque.

Ainsi, de manière avantageuse selon l'invention, l'utilisation de l'élément d'isolation permet d'empiler les cellules photovoltaïques sans que les faces avant et arrière de chaque cellule photovoltaïque ne subissent de contraintes au niveau des métallisations. Cela permet d'éviter des dégradations de performances électriques et de limiter la casse mécanique des cellules photovoltaïques.

De plus, grâce à la présence de l'élément d'isolation, lorsque les cellules photovoltaïques sont empilées, seul le bord périphérique de chaque cellule photovoltaïque est visible et accessible depuis l'extérieur de l'empilement. En d'autres termes, l'élément d'isolation isole la face avant et la face arrière de chaque cellule photovoltaïque de l'extérieur de l'empilement. Cela permet alors de s'assurer que seul le bord périphérique des cellules photovoltaïques est exposé à l'espèce de passivation pour le dépôt de la couche de passivation (les autres parties des cellules photovoltaïques étant isolées grâce à la présence des éléments d'isolation entre chaque cellule photovoltaïque, qui forment une barrière aux espèces de passivation utilisées).

La localisation du dépôt uniquement sur le bord périphérique (et non sur la totalité des faces de chaque cellule photovoltaïque) permet de faciliter l'étape d'interconnexion ultérieure des cellules photovoltaïques. Cela permet alors d'éviter la dégradation des performances électriques des cellules photovoltaïques.

Outre les caractéristiques qui viennent d'être évoquées dans les paragraphes précédents, le procédé de passivation selon l'invention peut présenter une ou plusieurs caractéristiques complémentaires parmi les suivantes, considérées individuellement ou selon toutes les combinaisons techniquement possibles :
- pour chaque cellule photovoltaïque de la pluralité de cellules photovoltaïques, le premier élément d'isolation est de préférence formé, sur l'une de la face avant ou de la face arrière, à une distance, du bord périphérique, inférieure à 50 micromètres ;
- le premier élément d'isolation présente une largeur inférieure à 100 micromètres ;
- le premier élément d'isolation présente une largeur comprise entre 30 et 60 micromètres ;
- chaque cellule photovoltaïque présentant, sur au moins l'une de la face avant et de la face arrière, au moins un élément de métallisation, le premier élément d'isolation présente une hauteur supérieure ou égale à la hauteur de l'élément de métallisation ;
- le premier élément d'isolation est formé d'un matériau métallique conducteur électriquement ;
- le premier élément d'isolation est formé par sérigraphie ;
- le premier élément d'isolation est formé d'un matériau polymère ;
- lors de l'étape d'empilement, les cellules photovoltaïques sont positionnées de telle manière que le premier élément d'isolation formé est en contact direct avec l'une des faces de la cellule photovoltaïque adjacente ;
- pour chaque cellule photovoltaïque, il est prévu une étape de formation d'un deuxième élément d'isolation le pourtour de la cellule photovoltaïque concernée, le deuxième élément d'isolation étant formé sur la même face que le premier élément d'isolation, en parallèle du premier élément d'isolation ;
- le deuxième élément d'isolation est formé à une distance du premier élément d'isolation inférieure à 50 micromètres ;
- pour chaque cellule photovoltaïque, il est prévu une étape de formation d'un troisième élément d'isolation conformé selon le pourtour de la cellule photovoltaïque concernée, le troisième élément d'isolation étant formé sur la face opposée à la face munie du premier élément d'isolation ;
- lors de l'étape d'empilement, les cellules photovoltaïques sont positionnées de telle sorte que le troisième élément d'isolation d'une cellule photovoltaïque est placé entre le premier élément d'isolation et le deuxième élément d'isolation de la cellule photovoltaïque adjacente, le troisième élément d'isolation étant en contact direct avec la face de la cellule photovoltaïque adjacente sur laquelle sont formés le premier élément d'isolation et le deuxième élément d'isolation ;
- pour chaque cellule photovoltaïque, il est prévu une étape de formation d'un quatrième élément d'isolation conformé selon le pourtour de la cellule photovoltaïque concernée, le quatrième élément d'isolation étant formé sur la face opposée à la face munie du premier élément d'isolation, le quatrième élément d'isolation étant formé en regard du premier élément d'isolation ; et
- lors de l'étape d'empilement, les cellules photovoltaïques sont positionnées de telle manière que le premier élément d'isolation d'une cellule photovoltaïque est en contact avec le quatrième élément d'isolation de la cellule photovoltaïque adjacente.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
La figure 1 est une vue du dessus d'une cellule photovoltaïque selon un premier mode de réalisation d'un procédé de passivation conforme à l'invention,
La figure 2 est une vue en coupe d'un empilement comprenant la cellule photovoltaïque de la figure 1,
La figure 3 est une vue du dessus d'une cellule photovoltaïque selon un deuxième mode de réalisation du procédé de passivation conforme à l'invention,
La figure 4 est une vue en coupe d'un empilement comprenant la cellule photovoltaïque de la figure 3,
La figure 5 représente une vue en coupe d'une cellule photovoltaïque selon un troisième mode de réalisation du procédé de passivation conforme à l'invention,
La figure 6 est une vue en coupe d'un empilement comprenant la cellule photovoltaïque de la figure 5,
La figure 7 représente une vue en coupe d'une cellule photovoltaïque selon un quatrième mode de réalisation du procédé de passivation conforme à l'invention,
La figure 8 est une vue en coupe d'un empilement comprenant la cellule photovoltaïque de la figure 7,
La figure 9 représente une vue en coupe d'une cellule photovoltaïque selon un cinquième mode de réalisation du procédé de passivation conforme à l'invention,
La figure 10 est une vue en coupe d'un empilement comprenant la cellule photovoltaïque de la figure 9.

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

La présente invention vise à améliorer la fabrication de cellules photovoltaïques et en particulier à améliorer la phase de passivation des cellules photovoltaïques. Elle vise notamment à limiter le dépôt de couches minces sur les tranches latérales des cellules photovoltaïques.

Les cellules photovoltaïques 5 concernées par la présente invention sont par exemple des cellules de pleine taille ou des sous-cellules, c'est-à-dire des portions ou morceaux d'une cellule photovoltaïque de pleine taille (aussi qualifiée de cellule photovoltaïque « entière »).

Les sous-cellules sont par exemple préalablement obtenues par découpage de cellules photovoltaïques de pleine taille.

Les cellules photovoltaïques de pleine taille ont été préalablement fabriquées à partir de substrats semi-conducteurs, par exemple en silicium cristallin. Ces substrats ont été initialement découpés dans un lingot de silicium, puis ont été soumis à plusieurs étapes de fabrication (par exemple des étapes de structuration de surface, dopage, recuit, passivation, sérigraphie...), mais aucune autre étape de découpage. Les cellules photovoltaïques de pleine taille présentent des couches de passivation sur l'ensemble de ses faces et surfaces latérales.

Les cellules photovoltaïques 5 concernées par la présente invention comprennent chacune une première face 5A et une deuxième face 5B, opposée à la première face 5A. La première face 5A est par exemple celle destinée à être exposée au rayonnement solaire incident. Dans ce cas, la première face 5A correspond à la face avant 5A de la cellule photovoltaïque 5 concernée. La suite de cette description se base sur cet exemple en considérant, pour chaque cellule photovoltaïque 5, la face avant 5A (exposée au rayonnement solaire incident) et la face arrière 5B (opposée à la face avant 5A).

Chaque cellule photovoltaïque 5 comprend également un bord périphérique 5C reliant la face avant 5A et la face arrière 5B. Ce bord périphérique 5C correspond donc à la surface latérale liant la face avant 5A et la face arrière 5B. Par définition ici, le bord périphérique 5C s'étend donc sur l'ensemble du pourtour de la face avant 5A et de la face arrière 5B de la cellule photovoltaïque 5. Dans la présente description, on entend par « pourtour » de la cellule photovoltaïque 5, la ligne de contour de la face avant 5A et/ou de la face arrière 5B.

Vues de face (depuis la face avant 5A ou la face arrière 5B), les cellules photovoltaïques 5 présentent de préférence une forme rectangulaire ou pseudo-rectangulaire. Dans le format pseudo-rectangulaire, les quatre coins des cellules photovoltaïques 5 sont tronqués ou arrondis. En particulier, les cellules photovoltaïques 5 peuvent présenter une forme carrée ou pseudo-carrée.

Le pourtour de la cellule photovoltaïque 5 présente donc ici une forme rectangulaire ou pseudo-rectangulaire (ou, dans le cas particulier, carrée ou pseudo-carrée).

Les dimensions de la face avant 5A et de la face arrière 5B sont généralement standardisées, par exemple 156 mm x 156 mm. Dans le cas des sous-cellules (issues du découpage d'une cellule photovoltaïque de pleine taille), ces dimensions sont par exemple de l'ordre de 156 mm x 78 mm

Les cellules photovoltaïques 5 peuvent être des cellules monofaciales ou bifaciales. Dans le cas d'une cellule monofaciale, seule la face avant 5A de la cellule photovoltaïque 5 capte le rayonnement solaire. Dans le cas d'une cellule bifaciale, les deux faces 5A, 5B de la cellule photovoltaïque 5 captent le rayonnement solaire. La face avant 5A est alors celle permettant d'obtenir le maximum de courant électrique lorsqu'elle est tournée vers le soleil.

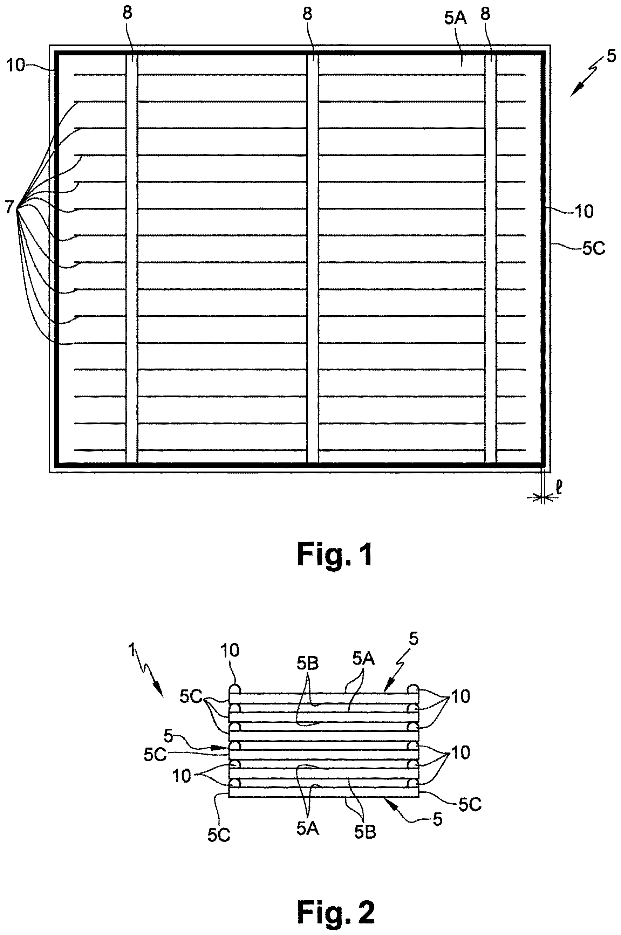

De préférence, les cellules photovoltaïques 5 sont prêtes à être interconnectées en une chaîne de cellules. Elles sont munies sur la face avant 5A et/ou sur la face arrière 5B d'un ou plusieurs éléments de métallisation 7, 8 (également appelés « métallisations 7, 8 » dans la suite) destinés à collecter les porteurs de charge photogénérés et à recevoir des éléments d'interconnexion, par exemple des fils ou rubans métalliques. Les métallisations 7, 8 ne sont ici représentées que sur la figure 1 mais sont présentes sur l'ensemble des cellules photovoltaïques 5 utilisées dans la présente invention.

Les métallisations 7, 8 sont de préférence ici un réseau d'électrodes 7 (également appelées « doigts de collecte 7 ») et des pistes électriquement conductrices d'interconnexion 8 appelées « busbars 8 ». Les busbars 8 peuvent relier électriquement des doigts de collecte 7 répartis sur toute la superficie de la face avant 5A et/ou de la face arrière 5B. La face arrière 5B des cellules photovoltaïques 5 peut aussi être entièrement métallisée.

Les électrodes formant les doigts de collecte 7 sont par exemple déposées sur la face avant 5A de la cellule photovoltaïque 5. Ces doigts de collecte 7 s'étendent en général parallèlement entre eux le long de la face avant 5A de chaque cellule photovoltaïque 5. Ils sont ici préférentiellement uniformément répartis sur la face avant 5A de chaque cellule photovoltaïque 5.

Les doigts de collecte 7 sont étroits, c'est-à-dire qu'ils présentent par exemple une largeur inférieure à 100 micromètres (µm). La largeur est de préférence inférieure à 50 µm. Ils présentent une hauteur de l'ordre de quelques dizaines de micromètres. De préférence, cette hauteur est inférieure à 30 µm. De préférence, cette hauteur est comprise entre 10 et 20 µm.

Ils sont généralement formés par sérigraphie d'une pâte contenant de l'argent ou du cuivre. En variante, ils peuvent être formés par dépôt par impression jet d'encre (ou « inkjet ») ou par revêtement métallique (ou « plating » selon le terme d'origine anglosaxonne couramment utilisé).

La face arrière 5B de la cellule photovoltaïque 5 est soit recouverte d'un autre réseau d'électrodes (cas des cellules bifaciales), soit d'une couche métallique pleine, par exemple en aluminium (cas des cellules monofaciales).

Afin de transporter le courant électrique dans une chaîne photovoltaïque comprenant plusieurs cellules photovoltaïques interconnectées, les doigts de collecte 7 sont reliés entre eux par les busbars 8. Ces busbars 8 sont généralement formés en même temps que les doigts de collecte 7. Les busbars 8 sont par exemple également formés par sérigraphie d'une pâte contenant de l'argent ou du cuivre. En variante, ils peuvent être formés par dépôt par impression jet d'encre (ou « inkjet ») ou par revêtement métallique (ou « plating » selon le terme d'origine anglosaxonne couramment utilisé).

Comme cela est visible par exemple sur la figure 1, les busbars 8 relient électriquement les doigts de collecte 7 et sont orientés perpendiculairement aux doigts de collecte 7. La cellule photovoltaïque 5 représentée schématiquement sur la figure 1 comprend ici trois busbars 8, s'étendant perpendiculairement à la pluralité de doigts de collecte 7 représentés. De préférence, chaque cellule photovoltaïque comprend entre 6 et 10 busbars.

Chaque busbar 8 présente une largeur supérieure ou égale à la largeur de chaque doigt de collecte 7. La largeur de chaque busbar est par exemple inférieure à quelques centaines de micromètres, par exemple inférieure à 500 µm. De préférence, la largeur de chaque busbar 8 est comprise entre 50 et 300 µm.

Chaque busbar 8 présente une hauteur supérieure ou égale à la hauteur de chaque doigt de collecte 7. La hauteur de chaque busbar 8 est ici inférieure à 50 µm. De préférence, elle est comprise entre 20 et 30 µm.

Dans une variante de mise en oeuvre (non représentée), les cellules photovoltaïques peuvent être dépourvues de busbars mais comportent uniquement des doigts de collecte.

Comme les cellules photovoltaïques 5 sont par exemple obtenues par découpage d'une cellule photovoltaïque de pleine taille dont les faces sont munies de couches de passivation, la face avant 5A et la face arrière 5B de chaque cellule photovoltaïque 5 présentent une couche de passivation. Cette couche de passivation rend inactifs les défauts de surface de la cellule photovoltaïque 5 et améliore la durée de vie des porteurs de charge photogénérés.

En revanche, le bord périphérique 5C de la cellule photovoltaïque comprend des zones où le matériau semi-conducteur (i.e. le silicium) a été mis à nu. Autrement dit, ces zones du bord périphérique 5C sont dépourvues de couche de passivation (à cause du découpage), à la différence de la face avant 5A, de la face arrière 5B et des (éventuelles) autres zones du bord périphérique 5C de la cellule photovoltaïque 5. Par exemple, lorsqu'une cellule photovoltaïque de pleine taille est découpée en quatre bandes de cellule parallèles, deux bandes de cellule présentent deux bords parallèles non passivés, et deux autres bandes de cellule présentent un seul bord non passivé.

Les cellules photovoltaïques 5 concernées peuvent également être des cellules de pleine taille sur lesquelles une partie du bord périphérique 5C a subi une abrasion. Cela est par exemple le cas lorsqu'une ouverture de jonction est mise en oeuvre afin d'éviter d'éventuels courts-circuits. Dans ce cas, le bord périphérique 5C de la cellule photovoltaïque 5 présente également une partie non passivée sur son bord périphérique 5C.

La présente invention vise donc à protéger, par formation d'une couche de passivation, ces zones dans lesquelles le matériau semi-conducteur est mis à nu, sans que ce dépôt n'atteigne la face avant 5A et la face arrière 5B de chaque cellule photovoltaïque 5 (car cela risquerait de dégrader les performances électriques de la cellule photovoltaïque 5).

Pour cela, la présente invention concerne un procédé de passivation des cellules photovoltaïques 5 de manière à former une couche de passivation sur une partie de chacune des cellules photovoltaïques 5.

Les figures 1 à 10 sont associées à différents modes de réalisation de ce procédé de passivation conforme à l'invention.

Il est à noter que, préalablement à la mise en oeuvre du procédé de passivation (quel que soit le mode de réalisation considéré), les cellules photovoltaïques 5 ont été fabriquées à partir de substrats semiconducteurs (par exemple en silicium cristallin). Elles ont également été par exemple découpées ou soumises à une abrasion d'une partie de leur bord périphérique après la fabrication des cellules photovoltaïques de pleine taille.

Les figures 1 et 2 correspondent au premier exemple de mise en oeuvre du procédé de passivation.

Ce procédé comprend tout d'abord une première étape de fourniture d'une pluralité de cellules photovoltaïques 5. Lors de cette étape, toutes les cellules photovoltaïques 5 de la pluralité de cellules photovoltaïques considérées présentent la même forme et les mêmes dimensions.

Le procédé se poursuit ensuite avec une deuxième étape de formation d'un élément d'isolation 10 sur chaque cellule photovoltaïque 5 de la pluralité de cellules photovoltaïques fournies. Par souci de clarté, cette deuxième étape est décrite en relation avec une cellule photovoltaïque 5 de la pluralité de cellules photovoltaïques fournies lors de la première étape mais s'applique de la même manière à toutes les cellules photovoltaïques de cette pluralité.

Selon le premier mode de réalisation du procédé de passivation, l'élément d'isolation 10 est formé sur l'une des faces 5A, 5B de la cellule photovoltaïque 5. Sur les figures 1 et 2, l'élément d'isolation 10 est ici formé sur la face avant 5A de la cellule photovoltaïque 5. En variante, l'élément d'isolation peut bien entendu être formé, de la même manière, sur la face arrière de la cellule photovoltaïque. Il est à noter ici que cet élément d'isolation 10 est distinct des éléments de métallisation 7, 8 déjà présents sur l'une ou les faces 5A, 5B de la cellule photovoltaïque 5. En particulier, l'élément d'isolation 10 est distinct des éventuels busbars présents sur la cellule photovoltaïque 5.

De manière avantageuse, comme cela est visible sur la figure 1, l'élément d'isolation 10 est conformé selon le pourtour de la cellule photovoltaïque 5. Autrement dit, l'élément d'isolation 10 présente la forme de la circonférence (c'est-à-dire de la limite extérieure) de la cellule photovoltaïque 5.

Ici, sachant que la cellule photovoltaïque 5 présente une forme rectangulaire, l'élément d'isolation 10 s'étend donc selon une forme rectangulaire correspondant à la périphérie de la cellule photovoltaïque 5 (comme cela est visible sur la figure 1).

En pratique, l'élément d'isolation 10 est formé (ici sur la face avant 5A de la cellule photovoltaïque 5) à proximité du bord périphérique 5C. Plus particulièrement, l'élément d'isolation 10 est de préférence formé à une distance inférieure à 50 µm du bord périphérique 5C (donc du bord de la face avant 5A de la cellule photovoltaïque 5).

L'élément d'isolation 10 présente ici une largeur l inférieure à 100 µm. Dans cette description, on entend par « largeur de l'élément d'isolation » la dimension dans une direction transversale de l'élément d'isolation 10. De préférence, cette largeur 1 est comprise entre 30 et 60 µm. La formation d'un élément d'isolation le plus fin possible permet de limiter l'ombrage parasite induit, c'est-à-dire l'ombre formée à cause de la présence de l'élément d'isolation 10, sur la cellule photovoltaïque 5 (une ombre trop importante réduirait la production électrique finale de la chaîne photovoltaïque comprenant la pluralité de cellules photovoltaïques connectées entre elles).

Par ailleurs, la hauteur de l'élément d'isolation 10 est ici supérieure ou égale à la hauteur des métallisations 7, 8 présentes sur la face avant 5A de la cellule photovoltaïque 5. Dans cette description, la « hauteur » de l'élément d'isolation 10 correspond à la dimension de l'élément d'isolation 10 dans une direction orthogonale à la face avant 5A de la cellule photovoltaïque 5. Cette condition sur la hauteur de l'élément d'isolation 10 permet d'éviter de dégrader les métallisations 7, 8 lorsque les cellules photovoltaïques 5 sont empilées les unes sur les autres (tel que décrit ci-après).

En pratique, la hauteur de l'élément d'isolation 10 est supérieure ou égale à la hauteur des busbars 8 (qui sont généralement les éléments de métallisation formés sur la face de la cellule photovoltaïque qui présentent la plus grande hauteur). Par exemple, la hauteur de l'élément d'isolation 10 est inférieure à 150 µm. De préférence, la hauteur de l'élément d'isolation 10 est comprise entre 50 et 130 µm.

L'élément d'isolation 10 se présente par exemple sous la forme d'un cordon s'étendant le long du pourtour de la cellule photovoltaïque 5. Ce cordon comprend par exemple une section transversale rectangulaire ou cylindrique. En variante, la section transversale de l'élément d'isolation peut être de forme quelconque.

Selon un premier exemple, l'élément d'isolation 10 est formé d'un matériau métallique conducteur électriquement. De manière avantageuse dans ce cas, si l'élément d'isolation 10 est raccordé électriquement aux éléments de métallisation 7, 8, cela permet de renforcer la prise de contact globale en cas de coupure de ligne.

Dans ce premier exemple, l'élément d'isolation 10 est par exemple formé par sérigraphie d'une pâte contenant de l'argent ou du cuivre. Dans ce cas, par souci d'efficacité et de simplification, l'élément d'isolation 10 est par exemple déposé en même temps que les éléments de métallisation 7, 8 de la cellule photovoltaïque 5. En variante, il peut être formé après fabrication des éléments de métallisation 7, 8.

En variante, l'élément d'isolation 10 peut être formé par dépôt par impression jet d'encre (ou « inkjet ») ou par revêtement métallique (ou « plating » selon le terme d'origine anglosaxonne couramment utilisé). Dans ces cas, l'élément d'isolation peut être formé simultanément ou après la formation des éléments de métallisation 7, 8.

Selon un deuxième exemple, l'élément d'isolation 10 est formé d'un matériau non conducteur électriquement. Tout type de matériau peut être envisagé.

De préférence, dans ce deuxième exemple, l'élément d'isolation 10 est formé est dans un matériau polymère. Il s'agit par exemple de dérivés du caoutchouc. Les produits commerciaux suivants peuvent être utilisés : PETERS SD 2052, MICROMAXO 5018 ou MICROMAXO 5036.

Il s'agit par exemple de matériaux polymères durs ou de matériaux polymères mous. Un matériau polymère mou est par exemple défini à partir de l'échelle de dureté standard Shore A. Dans le cadre de l'invention, les matériaux considérés présentent par exemple un indice compris entre 70 et 90 sur cette échelle Shore A. Il s'agit ici par exemple de fluoroélastomères.

En particulier, l'utilisation de matériau polymère mous permet d'obtenir un élément d'isolation transparent, limitant alors l'ombrage parasite induit sur la cellule photovoltaïque. Par transparent, on entend dans cette description un élément laissant passer plus de 70% du rayonnement incident, et de préférence au moins 80% du rayonnement incident, dans le spectre visible. Il s'agit par exemple de polymères du type PEDOT:PSS (formé d'un mélange de deux polymères, le poly(3,4-éthylènedioxythiophène) (PEDOT) et le poly(styrène sulfonate) de sodium (PSS)).

L'utilisation de matériaux polymères mous permet d'améliorer l'efficacité de la jointure entre l'élément d'isolation et la cellule photovoltaïque adjacente lors de l'empilement de la pluralité de cellules photovoltaïques (tel que décrit ci-après).

En variante, l'élément d'isolation peut être formé d'une résine. Cette résine est par exemple du polyamide, de l'acétonitrile butadiène styrène ou du polyester.

Finalement, dans ce premier mode de réalisation, à l'issue de la deuxième étape du procédé de passivation, chaque cellule photovoltaïque 5 de la pluralité de cellules photovoltaïques est munie d'un élément d'isolation 10 formé sur l'une de la face avant 5A ou de la face arrière 5B (en l'occurrence ici, tel que cela est représenté sur la figure 2, l'élément d'isolation 10 est formé sur la face avant 5A de chaque cellule photovoltaïque 5).

Le procédé de passivation se poursuit alors par une troisième étape d'empilement de la pluralité de cellules photovoltaïques 5 munies chacune de leur élément d'isolation 10 (un empilement 1, visible sur la figure 2, de cellules photovoltaïques et d'éléments d'isolation 10 est donc formé).

Dans cette description, on entend par « empilement » (ou « stacking » selon le terme d'origine anglosaxonne couramment utilisé) des cellules photovoltaïques, l'agencement de ces cellules photovoltaïques les unes à la suite des autres. Un groupe de cellules photovoltaïques 5 est donc formé.

Cet empilement 1 est par exemple mis en oeuvre verticalement : les cellules photovoltaïques 5 sont alors superposées les unes sur les autres (tel que cela est représenté sur la figure 2). En variante, l'empilement peut être réalisé de manière horizontale. Dans ce cas, les cellules photovoltaïques sont positionnées les unes à la suite des autres (elles sont juxtaposées).

En pratique, cet empilement est par exemple mis en oeuvre sur un support (non représenté) destiné à être positionné ensuite dans une enceinte de dépôt de couches minces (pour l'étape associée décrite ci-après).

De manière avantageuse selon l'invention, chaque cellule photovoltaïque 5 est positionnée de sorte que l'élément d'isolation 10 de la cellule photovoltaïque 5 concernée est placé entre cette cellule photovoltaïque 5 et la cellule photovoltaïque 5 adjacente. En d'autres termes, dans l'empilement 1, les cellules photovoltaïques 5 sont agencées les unes à la suite des autres avec le positionnement d'un élément d'isolation 10 entre deux cellules photovoltaïques 5 adjacentes. Cet agencement est mis en oeuvre de telle façon que la face avant 5A de la cellule photovoltaïque 5 munie de l'élément d'isolation 10 est positionnée à distance de la face arrière 5B de la cellule photovoltaïque 5 adjacente. Pour mémoire, les cellules photovoltaïques 5 considérées dans ce premier mode de réalisation présentent toutes la même configuration avec un élément d'isolation formé sur leur face avant 5A. Les faces des cellules photovoltaïques 5 ne sont donc pas en contact entre elles lorsque qu'elles sont empilées. Cela permet notamment d'éviter de dégrader les éléments de métallisation, et donc les performances électriques des cellules photovoltaïques.

Dans cette étape d'empilement, l'élément d'isolation 10 (d'une cellule photovoltaïque 5) est donc positionné en contact direct avec la face arrière 5B de la cellule photovoltaïque 5 adjacente.

Cette configuration est particulièrement avantageuse car elle permet d'empiler les cellules photovoltaïques 5 sans que les faces avant et arrière de chaque cellule photovoltaïque 5 ne subissent de contraintes au niveau des métallisations. Cela permet d'éviter des dégradations de performances électriques.

De plus, grâce à la présence de l'élément d'isolation 10, lorsque les cellules photovoltaïques 5 sont empilées, seul le bord périphérique 5C de chaque cellule photovoltaïque 5 est visible et accessible depuis l'extérieur de l'empilement 1. En d'autres termes, l'élément d'isolation 10 isole la face avant 5A et la face arrière 5B de chaque cellule photovoltaïque 5 de l'extérieur de l'empilement 1. Cela permet alors de s'assurer que seul le bord périphérique 5C des cellules photovoltaïques 5 est exposé à au moins une espèce de passivation pour le dépôt de la couche de passivation tel que décrit ci-après (les autres parties des cellules photovoltaïques 5 étant isolées grâce à la présence des éléments d'isolation entre chaque cellule photovoltaïque 5, qui forment une barrière à l'espèce (ou les espèces) de passivation utilisée(s)).

Le procédé de passivation comprend ensuite une étape de dépôt d'une couche de passivation sur une partie des cellules photovoltaïques 5 empilées. Pour cela, l'empilement 1 de cellules photovoltaïques 5 est par exemple placé dans une enceinte de dépôt de couches minces (non représentée sur les figures). La couche de passivation est formée à partir d'au moins une espèce de passivation. De préférence, cette espèce de passivation se présente sous la forme d'un gaz. Le dépôt de la couche de passivation est alors mis en oeuvre par injection de l'espèce de passivation dans l'enceinte de dépôt mentionnée.

En pratique, une couche de passivation est par exemple formée par dépôt de couches atomiques (ou ALD pour « *Atomic Layer Deposition* » selon l'acronyme d'origine anglo-saxonne couramment utilisé). Selon cette méthode, différents gaz précurseurs sont introduits dans l'enceinte de dépôt de couches minces et acheminés vers les différentes zones (ici le bord périphérique 5C de chaque cellule photovoltaïque 5) sur lesquelles une ou plusieurs couches atomiques doivent être déposées.

Une couche atomique est formée sur une zone concernée (i.e. ici le bord périphérique 5C de chaque cellule photovoltaïque 5) en exposant cette zone au flux d'un premier gaz précurseur injecté, dans l'enceinte de dépôt de couches minces, par des moyens d'injection (non représentés). Ce premier gaz précurseur réagit avec les terminaisons de la zone concernée et forme une monocouche contenant d'autres terminaisons (groupes réactifs). Un deuxième gaz précurseur (également injecté par les moyens d'injection) introduit ensuite réagit avec les terminaisons de la monocouche formée (à l'issue de l'injection du premier gaz précurseur) de manière à former la couche de passivation souhaitée.

En pratique, les moyens d'injection sont par exemple formés par une tête d'injection (non représentée) permettant l'introduction du gaz dans l'enceinte de dépôt de couches minces. Les conditions de dépôt (telles que la position de la tête d'injection, les débits des gaz, la concentration des précurseurs et la température) et les dimensions de la tête d'injection sont avantageusement choisies de façon à ce que la couche de passivation soit formée au niveau du bord périphérique 5C de chaque cellule photovoltaïque 5 de l'empilement 1.

De manière préférentielle, le matériau de la couche de passivation est par exemple de l'alumine (Al₂O₃), du dioxyde de silicium (SiO₂), du nitrure de silicium (Si₃N₄) ou du silicium amorphe hydrogéné (a-Siₓ :H).

L'épaisseur de la couche de passivation est de l'ordre de quelques nanomètres (nm) à quelques dizaines de nanomètres. Par exemple, dans le cas de l'alumine, l'épaisseur de la couche de passivation est supérieure à 5 nm, de préférence comprise entre 5 et 15 nm. Dans le cas du silicium amorphe hydrogéné, l'épaisseur de la couche de passivation est de préférence comprise entre 5 et 15 nm.

En variante, l'espèce de passivation peut se présenter sous la forme d'une solution liquide vaporisée. Il s'agit par exemple d'une solution liquide de polymère vaporisée. Le polymère est ici un fluoropolymère tel que le Nation^{™}.

Grâce à l'agencement décrit précédemment (formation d'un élément d'isolation 10 sur la face avant 5A de chaque cellule photovoltaïque 5 et empilement des cellules photovoltaïques 5 les unes à la suite des autres avec le positionnement d'un élément d'isolation 10 entre deux cellules photovoltaïques 5 adjacentes), seul le bord périphérique 5C de chaque cellule photovoltaïque 5 est exposé à l'espèce de passivation injectée dans l'enceinte de dépôt de couches minces. Ainsi, de manière avantageuse, les éléments d'isolation 10 forment une barrière empêchant la pénétration de l'espèce de passivation de sorte que la couche de passivation est formée uniquement sur le bord périphérique 5C de chaque cellule photovoltaïque 5 de l'empilement 1 (lorsque l'espèce de passivation injectée dans l'enceinte de dépôt de couches minces affleure le bord périphérique 5C de chaque cellule photovoltaïque 5). La localisation du dépôt uniquement sur le bord périphérique (et non sur la totalité des faces de chaque cellule photovoltaïque) permet en particulier de faciliter l'étape d'interconnexion ultérieure des cellules photovoltaïques. Cela permet alors d'éviter la dégradation des performances électriques des cellules photovoltaïques. De plus, la localisation du dépôt uniquement sur le bord périphérique de chaque cellule photovoltaïque permet d'éviter de dégrader l'absorption des photons incidents (le dépôt sur les faces de chaque cellule photovoltaïque entraîne une absorption parasite dans le spectre optique concerné et dégrade les propriétés de réflexion de la cellule photovoltaïque).

En variante, le dépôt de la couche de passivation peut être réalisé par d'autres méthodes. Par exemple, des méthodes de dépôt physique par phase vapeur (ou PVD pour « *Physical Vapor Deposition »* selon l'acronyme d'origine anglo-saxonne) ou de dépôt chimique en phase vapeur (ou CVD pour « *Chemical Vapor Deposition* ») peuvent être utilisées.

En variante encore, une méthode chimique de dépôt en phase liquide peut être utilisée.

En variante encore, des méthodes de dépôt sur la base de plasma peuvent également être utilisés. Dans un tel cas, les matériaux utilisés, en particulier pour les parties de support, doivent être adaptés pour être conducteurs. Pour cela, il est notamment possible d'utiliser du graphite.

En pratique, les deux cellules photovoltaïques d'extrémité de l'empilement ne sont pas utilisées par la suite car elles sont soit en contact direct avec le support pour le dépôt de la couche de passivation, soit soumises à la formation de la couche de passivation sur l'ensemble de l'une de ses faces. Ces deux cellules photovoltaïques sont en quelque sorte sacrifiées dans le processus de passivation.

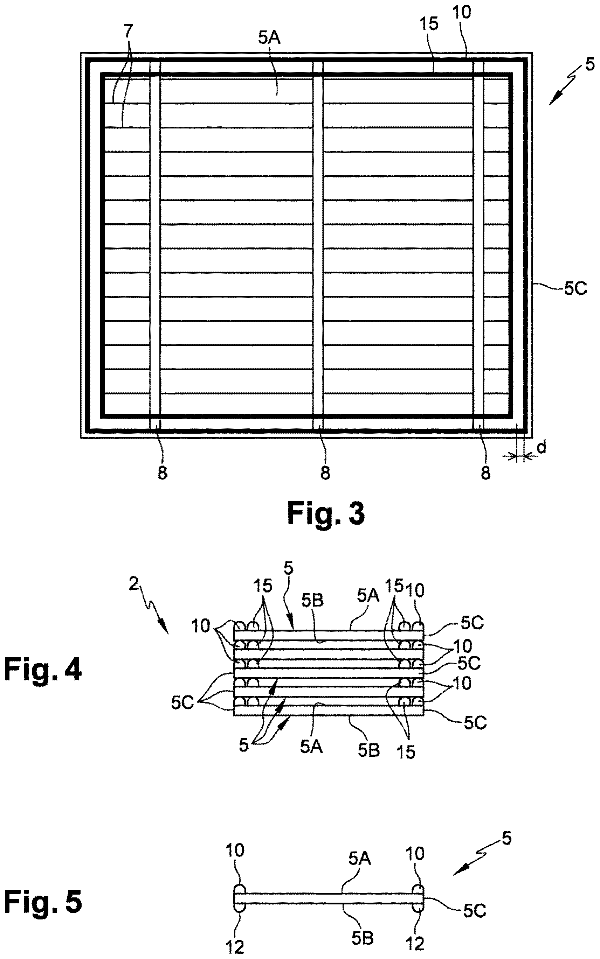

Les figures 3 et 4 correspondent à un deuxième exemple de mise en oeuvre du procédé de passivation conforme à l'invention.

Le procédé de passivation selon ce deuxième exemple comprend les mêmes étapes de fourniture de la pluralité de cellules photovoltaïques 5, de formation de l'élément d'isolation 10, d'empilement et de dépôt d'une couche de passivation que le premier mode de réalisation décrit précédemment. Aussi, seules les différences par rapport à ce premier exemple de réalisation sont décrites en détails dans la suite.

Dans ce deuxième mode de réalisation du procédé de passivation, avant l'étape d'empilement, le procédé de passivation comprend une étape de formation d'un autre élément d'isolation 15 (sur chaque cellule photovoltaïque 5 de la pluralité de cellules photovoltaïques).

Comme cela est visible sur les figures 3 et 4, cet autre élément d'isolation 15 est formé sur la même face que l'élément d'isolation 10 décrit précédemment. Ici, l'autre élément d'isolation 15 est donc formé sur la face avant 5A de chaque cellule photovoltaïque 5. En variante, si l'élément d'isolation est formé sur la face arrière de la cellule photovoltaïque, l'autre élément d'isolation est bien entendu formé, de la même manière, sur la face arrière de la cellule photovoltaïque.

Ici, comme cela est visible sur la figure 3, l'autre élément d'isolation 15 est conformé selon le pourtour de la cellule photovoltaïque 5. Il est donc, en pratique, conformé selon l'élément d'isolation 10 déjà formé. En d'autres termes, l'autre élément d'isolation 15 présente la même forme que l'élément d'isolation 10.

Ici, sachant que la cellule photovoltaïque 5 (et l'élément d'isolation 10) présente une forme rectangulaire, l'autre élément d'isolation 15 s'étend donc selon une forme rectangulaire correspondant à la périphérie de la cellule photovoltaïque 5 (comme cela est visible sur la figure 3).

En pratique, l'autre élément d'isolation 15 est formé à distance de l'élément d'isolation 10 (donc également à distance du bord périphérique 5C de la cellule photovoltaïque 5). La distance d entre l'élément d'isolation 10 et l'autre élément d'isolation 15 est inférieure à 100 µm. De préférence, cette distance d est inférieure à 50 µm.

Par exemple, l'autre élément d'isolation 15 est formé à une distance de l'élément d'isolation 10 de l'ordre de la largeur de cet élément d'isolation 10.

Pour une largeur de l'élément d'isolation 10 de l'ordre de 50 µm, l'autre élément d'isolation 15 est donc formé à une distance inférieure à 150 µm du bord périphérique 5C (donc du bord de la face avant 5A de la cellule photovoltaïque 5).

De plus, comme cela est représenté sur la figure 3, l'élément d'isolation 10 et l'autre élément d'isolation 15 s'étendent parallèlement.

Pour le reste, l'autre élément d'isolation 15 présente les mêmes caractéristiques que celles décrites précédemment pour l'élément d'isolation 10 (en particulier en ce qui concerne les dimensions de largeur et hauteur, la forme de la section transversale, ou les matériaux utilisés).

Il est à noter que les matériaux utilisés pour former l'élément d'isolation 10 et l'autre élément d'isolation 15 peuvent être différents.

Par ailleurs, dans ce deuxième mode de mise en oeuvre du procédé de passivation, il n'y a pas d'ordre de formation entre l'élément d'isolation 10 et l'autre élément d'isolation 15: l'un ou l'autre peut être formé en premier de manière indifférente. Ils peuvent en particulier être formés simultanément afin de simplifier la fabrication.

Ainsi, dans ce deuxième mode de réalisation, avant l'étape d'empilement, chaque cellule photovoltaïque 5 de la pluralité de cellules photovoltaïques est munie d'un élément d'isolation 10 et d'un autre élément d'isolation 15, formés tous les deux sur l'une de la face avant 5A ou de la face arrière 5B (en l'occurrence ici, tel que cela est représenté sur la figure 3, l'élément d'isolation 10 et l'autre élément d'isolation 15 sont formés sur la face avant 5A de chaque cellule photovoltaïque 5). L'élément d'isolation 10 forme par exemple un élément d'isolation extérieur 10 (car le plus proche du bord de la cellule photovoltaïque 5) et l'autre élément d'isolation 15 forme un élément d'isolation intérieur 15 (relativement à son positionnement « plus intérieur » sur la face de la cellule photovoltaïque 5).

Le procédé de passivation se poursuit alors par l'étape d'empilement de la pluralité de cellules photovoltaïques 5 munies chacune de l'élément d'isolation 10 et de l'autre élément d'isolation 15 (un empilement 2, visible sur la figure 4, de cellules photovoltaïques, d'éléments d'isolation 10 et d'autres éléments d'isolation 15 est donc formé).

Cet empilement 2 est ici mis en oeuvre verticalement : les cellules photovoltaïques 5 sont alors superposées les unes sur les autres (tel que cela est représenté sur la figure 4). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 5 est positionnée de sorte que l'élément d'isolation 10 et l'autre élément d'isolation 15 de la cellule photovoltaïque 5 concernée sont placés entre cette cellule photovoltaïque 5 et la cellule photovoltaïque 5 adjacente. En d'autres termes, dans l'empilement 2, les cellules photovoltaïques 5 sont agencées les unes à la suite des autres avec le positionnement d'un élément d'isolation 10 et d'un autre élément d'isolation 15 entre deux cellules photovoltaïques 5 adjacentes.

Cet agencement est mis en oeuvre de telle façon que la face avant 5A de la cellule photovoltaïque 5 munie de l'élément d'isolation 10 et de l'autre élément d'isolation 15 est positionnée à distance de la face arrière 5B de la cellule photovoltaïque 5 adjacente. Pour mémoire, les cellules photovoltaïques 5 considérées dans ce deuxième mode de réalisation présentent toutes la même configuration avec un élément d'isolation 10 et un autre élément d'isolation 15 formés sur leur face avant 5A. Les faces des cellules photovoltaïques 5 ne sont donc pas en contact entre elles lorsque qu'elles sont empilées. Cela permet notamment d'éviter de dégrader les éléments de métallisation, et donc les performances électriques des cellules photovoltaïques.

Dans cette étape d'empilement, l'élément d'isolation 10 et l'autre élément d'isolation 15 (d'une cellule photovoltaïque 5) sont donc positionnés en contact direct avec la face arrière 5B de la cellule photovoltaïque 5 adjacente.

En plus des avantages présentés pour le premier mode de réalisation, la configuration du deuxième mode de mise en oeuvre est particulièrement avantageuse car, grâce à la présence de l'autre élément d'isolation, elle permet de renforcer l'effet de barrière à la pénétration des espèces de passivation utilisées pour le dépôt de la couche mince. L'élément d'isolation 10 et l'autre élément d'isolation 15 forment donc une double barrière permettant d'isoler la face avant 5A et la face arrière 5B de chaque cellule photovoltaïque 5 de l'extérieur de l'empilement 2. Cela permet de s'assurer, encore plus, que seul le bord périphérique 5C des cellules photovoltaïques 5 est exposé aux espèces de passivation pour le dépôt de la couche de passivation (les autres parties des cellules photovoltaïques 5 étant isolées grâce à la présence des éléments d'isolation et autres éléments d'isolation entre chaque cellule photovoltaïque 5, qui forment une double barrière aux espèces de passivation utilisées).

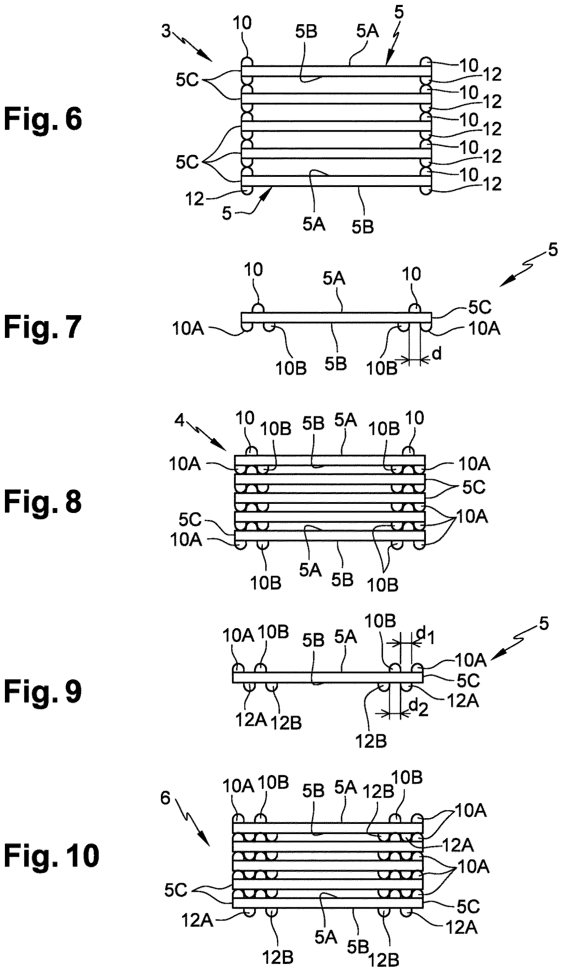

Les figures 5 et 6 correspondent à un troisième exemple de mise en oeuvre du procédé de passivation conforme à l'invention.

Le procédé de passivation selon ce troisième exemple comprend les mêmes étapes de fourniture de la pluralité de cellules photovoltaïques, de formation de l'élément d'isolation, d'empilement et de dépôt d'une couche de passivation que le premier mode de réalisation décrit précédemment. Aussi, seules les différences par rapport à ce premier exemple de réalisation sont décrites en détails dans la suite.

Dans ce troisième mode de réalisation du procédé de passivation, avant l'étape d'empilement, le procédé de passivation comprend une étape de formation d'un autre élément d'isolation 12 (sur chaque cellule photovoltaïque 5 de la pluralité de cellules photovoltaïques).

Comme cela est visible sur les figures 5 et 6, cet autre élément d'isolation 12 est formé sur la face opposée à celle sur laquelle est formé l'élément d'isolation 10 décrit selon le premier mode de réalisation. Ici, l'autre élément d'isolation 12 est donc formé sur la face arrière 5B de chaque cellule photovoltaïque 5. En variante, si l'élément d'isolation est formé sur la face arrière de la cellule photovoltaïque, l'autre élément d'isolation est bien entendu formé, de la même manière, sur la face avant de la cellule photovoltaïque.

L'autre élément d'isolation 12 est formé, sur la face arrière de la cellule photovoltaïque 5, de la même façon qu'est formé l'élément d'isolation 10 sur la face avant 5A (tel que cela est décrit précédemment).

Ainsi, l'autre élément d'isolation 12 est conformé selon le pourtour de la cellule photovoltaïque 5. Autrement dit, l'autre élément d'isolation 12 présente la forme de la circonférence (c'est-à-dire de la limite extérieure) de la cellule photovoltaïque 5.

Il est donc, en pratique, conformé selon l'élément d'isolation 10 déjà formé. En d'autres termes, l'autre élément d'isolation 12 présente la même forme que l'élément d'isolation 10.

Ici, sachant que la cellule photovoltaïque 5 (et l'élément d'isolation 10) présente une forme rectangulaire, l'autre élément d'isolation 12 s'étend donc selon une forme rectangulaire correspondant à la périphérie de la cellule photovoltaïque 5.

En pratique, comme cela est décrit pour l'élément d'isolation 10, l'autre élément d'isolation 12 est formé (ici sur la face arrière 5B de la cellule photovoltaïque 5) à proximité du bord périphérique 5C. Plus particulièrement, l'autre élément d'isolation 12 est formé à une distance inférieure à 50 µm du bord périphérique 5C (donc du bord de la face arrière 5B de la cellule photovoltaïque 5). Autrement dit, l'autre élément d'isolation 12 est formé en regard de l'élément d'isolation 10.

Pour le reste, l'autre élément d'isolation 12 présente les mêmes caractéristiques que celles décrites précédemment pour l'élément d'isolation 10 (en particulier en ce qui concerne les dimensions de largeur et hauteur, la forme de la section transversale ou les matériaux utilisés).

Il est à noter que les matériaux utilisés pour former l'élément d'isolation 10 et l'autre élément d'isolation 12 peuvent être différents.

Par ailleurs, dans ce troisième mode de mise en oeuvre du procédé de passivation, il n'y a pas d'ordre de formation entre l'élément d'isolation 10 et l'autre élément d'isolation 12 : l'un ou l'autre peut être formé en premier de manière indifférente. Ils peuvent en particulier être formés simultanément afin de simplifier la fabrication.

Ainsi, dans ce troisième mode de réalisation, avant l'étape d'empilement, chaque cellule photovoltaïque 5 de la pluralité de cellules photovoltaïques est munie d'un élément d'isolation 10 et d'un autre élément d'isolation 12, chacun étant formé sur des faces différentes de la cellule photovoltaïque 5 (en l'occurrence ici, tel que cela est représenté sur les figures 5 et 6, l'élément d'isolation 10 est formé sur la face avant 5A de chaque cellule photovoltaïque 5 et l'autre élément d'isolation 12 est formé sur la face arrière 5B de chaque cellule photovoltaïque 5).

Le procédé de passivation se poursuit alors par l'étape d'empilement de la pluralité de cellules photovoltaïques 5 munies chacune de l'élément d'isolation 10 et de l'autre élément d'isolation 12 (un empilement 3, visible sur la figure 6, de cellules photovoltaïques 5, d'éléments d'isolation 10 et d'autres éléments d'isolation 12 est donc formé).

Cet empilement 3 est ici mis en oeuvre verticalement : les cellules photovoltaïques 5 sont alors superposées les unes sur les autres (tel que cela est représenté sur la figure 6). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 5 est positionnée de sorte que l'élément d'isolation 10 de la cellule photovoltaïque 5 concernée et l'autre élément d'isolation 12 de la cellule photovoltaïque 5 adjacente sont placés entre cette cellule photovoltaïque 5 et la cellule photovoltaïque 5 adjacente. En d'autres termes, dans l'empilement 3, les cellules photovoltaïques 5 sont agencées les unes à la suite des autres avec le positionnement d'un élément d'isolation 10 d'une cellule photovoltaïque 5 et d'un autre élément d'isolation 12 d'une cellule photovoltaïque adjacente entre deux cellules photovoltaïques 5 adjacentes.

Autrement dit encore, cet agencement est mis en oeuvre de telle façon que la face avant 5A de la cellule photovoltaïque 5 munie de l'élément d'isolation 10 est positionnée à distance de la face arrière 5B de la cellule photovoltaïque 5 adjacente munie de l'autre élément d'isolation 12. Pour mémoire, les cellules photovoltaïques 5 considérées dans ce troisième mode de réalisation présentent toutes la même configuration avec un élément d'isolation 10 formé sur la face avant 5A et un autre élément d'isolation 12 formé sur la face arrière 5B. Les faces des cellules photovoltaïques 5 ne sont donc pas en contact entre elles lorsque qu'elles sont empilées. Cela permet notamment d'éviter de dégrader les éléments de métallisation, et donc les performances électriques des cellules photovoltaïques.

Dans cette étape d'empilement, comme représenté sur la figure 6, l'élément d'isolation 10 d'une cellule photovoltaïque 5 et l'autre élément d'isolation 12 d'une autre cellule photovoltaïque 5 adjacente sont donc positionnés en contact direct.

En plus des avantages présentés pour le premier mode de réalisation, la configuration du troisième mode de mise en oeuvre est particulièrement avantageuse car elle permet de limiter les points d'appui sur les cellules photovoltaïques lors de l'empilement. L'effet de barrière à la pénétration des espèces de passivation réactives est également renforcé.

Les figures 7 et 8 correspondent à un quatrième exemple de mise en oeuvre du procédé de passivation conforme à l'invention.

Le procédé de passivation selon ce quatrième exemple correspond, en quelque sorte, à une combinaison du premier et du deuxième mode de réalisation décrit précédemment. Seules les spécificités liées à ce quatrième mode de réalisation sont décrites ci-après.

Après l'étape de fourniture de la pluralité de cellules photovoltaïques 5 et avant l'étape d'empilement, le procédé de passivation selon ce quatrième exemple comprend une étape de formation d'un élément d'isolation 10C selon le premier exemple. Cet élément de formation 10C est formé sur l'une des faces 5A, 5B de chaque cellule photovoltaïque 5. Ici, l'élément d'isolation 10C est formé sur la face avant 5A de chaque cellule photovoltaïque 5 (figures 7 et 8).

Il comprend également une étape de formation d'un élément d'isolation « double » 10A, 10B selon le deuxième exemple décrit précédemment. Cet élément d'isolation « double » 10A, 10B comprend un élément d'isolation extérieur 10A (correspondant à l'élément d'isolation 10 du deuxième mode de réalisation décrit précédemment) et un élément d'isolation intérieur 10B (correspondant à l'autre élément d'isolation 15 du deuxième mode de réalisation).

Comme cela est visible sur les figures 7 et 8, l'élément d'isolation extérieur 10A et l'élément d'isolation intérieur 10B sont formés sur la face opposée à la face munie de l'élément d'isolation 10C. Ici, l'élément d'isolation extérieur 10A et l'élément d'isolation intérieur 10B sont donc formés sur la face arrière 5B de la cellule photovoltaïque 5.

En d'autres termes, dans ce quatrième mode de réalisation, la cellule photovoltaïque 5 comprend, sur l'une de ses faces, l'élément d'isolation 10C et, sur l'autre de ses faces, l'élément d'isolation extérieur 10A et l'élément d'isolation intérieur 10B.

La spécificité de ce quatrième exemple de mise en oeuvre du procédé de passivation réside sur le positionnement de l'élément d'isolation 10 par rapport à l'élément d'isolation extérieur 10A et l'élément d'isolation intérieur 10B.

Comme décrit pour le deuxième mode de réalisation introduit précédemment, l'élément d'isolation extérieur 10A et l'élément d'isolation intérieur 10B sont formés à distance l'un de l'autre. Un espace est donc défini entre l'élément d'isolation extérieur 10A et l'élément d'isolation intérieur 10B.

Dans ce quatrième exemple, de manière avantageuse, l'élément d'isolation 10C est formé en regard de l'espace défini entre l'élément d'isolation extérieur 10A et l'élément d'isolation intérieur 10B. Ce positionnement permet alors, lors de l'étape d'empilement décrite ci-après, de positionner l'élément d'isolation 10C d'une cellule photovoltaïque 5 entre l'élément d'isolation extérieur 10A et l'élément d'isolation intérieur 10B de la cellule photovoltaïque 5 adjacente.

En pratique, sur la face arrière 5B de la cellule photovoltaïque 5, l'élément d'isolation extérieur 10A est formé à proximité du bord périphérique 5C. Plus particulièrement, il est formé à une distance inférieure à 50 µm du bord périphérique 5C (donc du bord de la face avant 5A de la cellule photovoltaïque 5).

L'élément d'isolation intérieur 10B s'étend, à distance de l'élément d'isolation extérieur 10A, parallèlement à cet élément d'isolation extérieur 10A. La distance d entre l'élément d'isolation extérieur 10A et l'élément d'isolation intérieur 10B est inférieure à 100 µm. De préférence, cette distance d est inférieure à 50 µm.

Par exemple, l'élément d'isolation intérieur 10B est formé à une distance de l'élément d'isolation extérieur 10A de l'ordre de la largeur de l'élément d'isolation extérieur 10A.

Pour une largeur de l'élément d'isolation extérieur 10A de l'ordre de 50 µm, l'élément d'isolation intérieur 10B est donc formé à une distance inférieure à 150 µm du bord périphérique 5C (donc du bord de la face arrière 5B de la cellule photovoltaïque 5).

Sur la face avant 5A de la cellule photovoltaïque 5, l'élément d'isolation 10C est, quant à lui, formé à une distance prédéterminée du bord périphérique 5C de la cellule photovoltaïque 5 de sorte qu'il soit positionné en regard de l'espace défini entre l'élément d'isolation extérieur 10A et l'élément d'isolation intérieur 10B. Avec les exemples de distances de positionnement fournis précédemment pour l'élément d'isolation extérieur 10A et l'élément d'isolation intérieur 10B, l'élément d'isolation 10 est ici formé à une distance comprise entre 100 et 150 µm du bord périphérique 5C (donc du bord de la face avant 5A de la cellule photovoltaïque 5).

Pour le reste, l'élément d'isolation 10C, l'élément d'isolation extérieur 10A et l'élément d'isolation intérieur 10B présentent les mêmes caractéristiques que celles décrites précédemment dans les premier et deuxième exemples de mise en oeuvre du procédé de passivation (en particulier en ce qui concerne les dimensions de largeur et hauteur, la forme de la section transversale, de matériaux utilisés).

Il est à noter que les matériaux utilisés pour former l'élément d'isolation 10C, l'élément d'isolation extérieur 10A et l'élément d'isolation intérieur 10B peuvent être différents.

Par ailleurs, dans ce quatrième mode de mise en oeuvre du procédé de passivation, il n'y a pas d'ordre de formation entre l'élément d'isolation 10C, l'élément d'isolation extérieur 10A et l'élément d'isolation intérieur 10B. Ils peuvent en particulier être formés simultanément afin de simplifier la fabrication.

Ainsi, dans ce quatrième mode de réalisation (figures 7 et 8), avant l'étape d'empilement, chaque cellule photovoltaïque 5 de la pluralité de cellules photovoltaïques est munie, d'une part, d'un élément d'isolation 10C sur l'une des faces (ici la face avant 5A) et, d'autre part, de l'élément d'isolation extérieur 10A et l'élément d'isolation intérieur 10B, formés tous les deux sur l'autre des faces (ici la face arrière 5B).

Le procédé de passivation se poursuit alors par l'étape d'empilement de la pluralité de cellules photovoltaïques 5 munies chacune de l'élément d'isolation 10C, de l'élément d'isolation extérieur 10A et de l'élément d'isolation intérieur 10B (un empilement 4, visible sur la figure 8, de cellules photovoltaïques, d'éléments d'isolation 10C, d'éléments d'isolation extérieurs 10A et d'éléments d'isolation intérieurs 10B est donc formé).

Cet empilement 4 est ici mis en oeuvre verticalement : les cellules photovoltaïques 5 sont alors superposées les unes sur les autres (tel que cela est représenté sur la figure 8). En variante, l'empilement peut être réalisé de manière horizontale. Dans ce cas, les cellules photovoltaïques sont positionnées les unes à la suite des autres.

De manière avantageuse selon l'invention, chaque cellule photovoltaïque 5 est positionnée de sorte que l'élément d'isolation 10C d'une cellule photovoltaïque et l'élément d'isolation extérieur 10A et l'élément d'isolation intérieur 10B de la cellule photovoltaïque 5 adjacente sont placés entre cette cellule photovoltaïque 5 et la cellule photovoltaïque 5 adjacente. En d'autres termes, dans l'empilement 4, les cellules photovoltaïques 5 sont agencées les unes à la suite des autres avec le positionnement d'un élément d'isolation 10 d'une cellule photovoltaïque 5 et d'un élément d'isolation extérieur 10A et d'un élément d'isolation intérieur 10B d'une cellule photovoltaïque adjacente entre deux cellules photovoltaïques 5 adjacentes.

Autrement dit encore, cet agencement est mis en oeuvre de telle façon que la face avant 5A de la cellule photovoltaïque 5 munie de l'élément d'isolation 10 est positionnée à distance de la face arrière 5B de la cellule photovoltaïque 5 adjacente munie de l'élément d'isolation extérieur 10A et de l'élément d'isolation intérieur 10B. Pour mémoire, les cellules photovoltaïques 5 considérées dans ce quatrième mode de réalisation présentent toutes la même configuration avec un élément d'isolation 10C formé sur la face avant 5A et un élément d'isolation extérieur 10A et un élément d'isolation intérieur 10B formés sur la face arrière 5B. Les faces des cellules photovoltaïques 5 ne sont donc pas en contact entre elles lorsque qu'elles sont empilées. Cela permet notamment d'éviter de dégrader les éléments de métallisation, et donc les performances électriques des cellules photovoltaïques.

De manière avantageuse ici, et grâce à l'agencement de l'élément d'isolation 10C, de l'élément d'isolation extérieur 10A et de l'élément d'isolation intérieur 10B, l'empilement des cellules photovoltaïques 5 est mis en oeuvre de telle façon que l'élément d'isolation 10C d'une cellule photovoltaïque 5 est positionné entre l'élément d'isolation extérieur 10A et l'élément d'isolation intérieur 10B de la cellule photovoltaïque 5 adjacente. Cette configuration est visible sur la figure 8.

En plus des avantages présentés pour les premier et deuxième modes de réalisation, la configuration du quatrième mode de mise en oeuvre est particulièrement avantageuse car, grâce à l'agencement, en alternance et de manière juxtaposée, de l'élément d'isolation 10C, de l'élément d'isolation extérieur 10A et de l'élément d'isolation intérieur 10B, elle permet de renforcer l'effet de barrière à la pénétration des espèces de passivation utilisées pour le dépôt. L'élément d'isolation 10C, l'élément d'isolation extérieur 10A et l'élément d'isolation intérieur 10B forment donc une triple barrière permettant d'isoler la face avant 5A et la face arrière 5B de chaque cellule photovoltaïque 5 de l'extérieur de l'empilement 4. Cela permet de s'assurer, encore plus, que seul le bord périphérique 5C des cellules photovoltaïques 5 est exposé aux espèces de passivation pour le dépôt de la couche de passivation (les autres parties des cellules photovoltaïques 5 étant isolées grâce à la présence de l'élément d'isolation 10C, de l'élément d'isolation extérieur 10A et de l'élément d'isolation intérieur 10B entre chaque cellule photovoltaïque 5, qui forment une triple barrière aux espèces de passivation utilisées).

Par ailleurs, le positionnement de l'élément d'isolation 10C entre l'élément d'isolation extérieur 10A et l'élément d'isolation intérieur 10B permet de garantir un bon alignement des cellules photovoltaïques 5 lors de leur empilement (garantissant également la formation de la couche de passivation sur les bords périphériques 5C des cellules photovoltaïques 5 empilées).

Les figures 9 et 10 correspondent à un cinquième exemple de mise en oeuvre du procédé de passivation conforme à l'invention.

Le procédé de passivation selon ce cinquième exemple comprend les mêmes étapes de fourniture de la pluralité de cellules photovoltaïques, de formation des éléments d'isolation, d'empilement et de dépôt d'une couche de passivation que le deuxième mode de réalisation décrit précédemment. Aussi, seules les différences par rapport à ce deuxième exemple de réalisation sont décrites en détails dans la suite.

Ainsi, sur la base de ce qui est décrit pour le deuxième mode de réalisation, l'une des faces (par exemple la face avant) de chaque cellule photovoltaïque 5 est munie d'un élément d'isolation extérieur 10A (correspondant à l'élément d'isolation 10 du deuxième mode de réalisation) et d'un élément d'isolation intérieur 10B (correspondant à l'autre élément d'isolation 15 du deuxième mode de réalisation).

Dans ce cinquième mode de réalisation du procédé de passivation, avant l'étape d'empilement, le procédé de passivation comprend une étape de formation d'un autre élément d'isolation extérieur 12A et d'un autre élément d'isolation intérieur 12B (sur chaque cellule photovoltaïque 5 de la pluralité de cellules photovoltaïques).

Comme cela est visible sur les figures 9 et 10, l'autre élément d'isolation extérieur 12A et l'autre élément d'isolation intérieur 12B sont formés sur la face opposée à celle sur laquelle sont formés l'élément d'isolation extérieur 10A et l'élément d'isolation intérieur 10B (décrit selon le deuxième exemple de mise en oeuvre). Ici, l'autre élément d'isolation extérieur 12A et l'autre élément d'isolation intérieur 12B sont donc formés sur la face arrière 5B de la cellule photovoltaïque. En variante, si l'élément d'isolation extérieur et l'élément d'isolation intérieur sont formés sur la face arrière de la cellule photovoltaïque, l'autre élément d'isolation extérieur et l'autre élément d'isolation intérieur sont bien entendu formés, de la même manière, sur la face avant de la cellule photovoltaïque.

L'autre élément d'isolation extérieur 12A et l'autre élément d'isolation intérieur 12B sont formés, sur la face arrière 5B de la cellule photovoltaïque 5, de la même façon que sont formés l'élément d'isolation extérieur 10A et l'élément d'isolation intérieur 10B sur la face avant 5A.

La spécificité de ce cinquième exemple de mise en oeuvre du procédé de passivation réside sur le positionnement de l'autre élément d'isolation extérieur 12A et de l'autre élément d'isolation intérieur 12B (par rapport à l'élément d'isolation extérieur 10A et l'élément d'isolation intérieur 10B).

Comme décrit pour le deuxième mode de réalisation introduit précédemment, l'autre élément d'isolation extérieur 12A et l'autre élément d'isolation intérieur 12B sont formés à distance l'un de l'autre. Un espace est donc défini entre l'autre élément d'isolation extérieur 10A et l'autre élément d'isolation intérieur 10B.

Dans ce cinquième exemple, de manière avantageuse, l'autre élément d'isolation extérieur 12A est formé en regard de l'espace défini entre l'élément d'isolation extérieur 10A et l'élément d'isolation intérieur 10B. Ce positionnement permet alors, lors de l'étape d'empilement décrite ci-après, de positionner l'autre élément d'isolation extérieur 12A d'une cellule photovoltaïque 5 entre l'élément d'isolation extérieur 10A et l'élément d'isolation intérieur 10B de la cellule photovoltaïque 5 adjacente.

En pratique, sur la face avant 5A de la cellule photovoltaïque 5, l'élément d'isolation extérieur 10A est formé à proximité du bord périphérique 5C. Plus particulièrement, il est formé à une distance inférieure à 50 µm du bord périphérique 5C (donc du bord de la face avant 5A de la cellule photovoltaïque 5).

L'élément d'isolation intérieur 10B s'étend, à distance de l'élément d'isolation extérieur 10A, parallèlement à cet élément d'isolation extérieur 10A. La distance d₁ entre l'élément d'isolation extérieur 10A et l'élément d'isolation intérieur 10B est inférieure à 100 µm. De préférence, cette distance d₁ est inférieure à 50 µm.

Par exemple, l'élément d'isolation intérieur 10B est formé à une distance de l'élément d'isolation extérieur 10A de l'ordre de la largeur de l'élément d'isolation extérieur 10A.

Pour une largeur de l'élément d'isolation extérieur 10A de l'ordre de 50 µm, l'élément d'isolation intérieur 10B est donc formé à une distance inférieure à 150 µm du bord périphérique 5C (donc du bord de la face avant 5A de la cellule photovoltaïque 5).

Sur la face arrière 5B de la cellule photovoltaïque 5, l'élément d'isolation extérieur 12A est, quant à lui, formé à une distance prédéterminée du bord périphérique 5C de la cellule photovoltaïque 5 de sorte qu'il soit positionné en regard de l'espace défini entre l'élément d'isolation extérieur 10A et l'élément d'isolation intérieur 10B (formés sur la face avant 5A de la cellule photovoltaïque 5). Avec les exemples de distances de positionnement fournis précédemment pour l'élément d'isolation extérieur 10A et l'élément d'isolation intérieur 10B, l'autre élément d'isolation extérieur 12A est ici à une distance comprise entre 100 et 150 µm du bord périphérique 5C (donc du bord de la face arrière 5B de la cellule photovoltaïque 5).

L'autre élément d'isolation intérieur 12B est formé, par rapport à l'autre élément d'isolation extérieur 12A, de la même façon que l'élément d'isolation intérieur 10B est formé par rapport à l'élément d'isolation extérieur 10A.

En particulier, l'autre élément d'isolation intérieur 12B est formé à distance de l'autre élément d'isolation extérieur 12A (donc également à distance du bord périphérique 5C de la cellule photovoltaïque 5). Par exemple, la distance d₂ entre l'autre élément d'isolation extérieur 12A et l'autre élément d'isolation intérieur 12B est inférieure à 100 µm. De préférence, cette distance d₂ est inférieure à 50 µm.

Par exemple, l'autre élément d'isolation intérieur 12B est formé à une distance de l'autre élément d'isolation extérieur 12A de l'ordre de la largeur de l'élément d'isolation extérieur 10A.

Le distance entre l'élément d'isolation extérieur 10A et l'élément d'isolation intérieur 10B, d'une part, et l'autre élément d'isolation extérieur 12A et l'autre élément d'isolation intérieur 12B, d'autre part, est par exemple identique. En variante, elle peut bien entendu être différente.

Pour le reste, l'élément d'isolation extérieur 10A, l'élément d'isolation intérieur 10B, l'autre élément d'isolation extérieur 12A et l'autre élément d'isolation intérieur 12B présentent les mêmes caractéristiques que celles décrites précédemment dans le deuxième exemple de mise en oeuvre du procédé de passivation (en particulier en ce qui concerne les dimensions de largeur et hauteur, la forme de la section transversale et les matériaux utilisés).

Il est à noter que les matériaux utilisés pour former l'élément d'isolation extérieur 10A, l'élément d'isolation intérieur 10B, l'autre élément d'isolation extérieur 12A et l'autre élément d'isolation intérieur 12B peuvent être différents.

Par ailleurs, dans ce cinquième mode de mise en oeuvre du procédé de passivation, il n'y a pas d'ordre de formation entre l'élément d'isolation extérieur 10A, l'élément d'isolation intérieur 10B, l'autre élément d'isolation extérieur 12A et l'autre élément d'isolation intérieur 12B. Ils peuvent en particulier être formés simultanément, d'une part, sur la face avant et, d'autre part, sur la face arrière, afin de simplifier la fabrication. Il n'y a pas d'ordre de formation entre les éléments d'isolation de la face avant et les éléments d'isolation de la face arrière.

Ainsi, dans ce cinquième mode de réalisation (figures 9 et 10), avant l'étape d'empilement, chaque cellule photovoltaïque 5 de la pluralité de cellules photovoltaïques est munie, d'une part, d'un élément d'isolation extérieur 10A et d'un élément d'isolation intérieur 10B sur l'une des faces (ici la face avant 5A) et, d'autre part, de l'autre élément d'isolation extérieur 12A et de l'autre élément d'isolation intérieur 12B, formés tous les deux sur l'autre des faces (ici la face arrière 5B) de la cellule photovoltaïque 5.

Le procédé de passivation se poursuit alors par l'étape d'empilement de la pluralité de cellules photovoltaïques 5 munies chacune de l'élément d'isolation extérieur 10A, de l'élément d'isolation intérieur 10B, de l'autre élément d'isolation extérieur 12A et de l'autre élément d'isolation 12B (un empilement 6, visible sur la figure 10, de cellules photovoltaïques, d'éléments d'isolation extérieurs 10A, d'éléments d'isolation intérieurs 10B, d'autres éléments d'isolation extérieurs 12A et d'autres éléments d'isolation intérieur 12B est donc formé).

Cet empilement 6 est ici mis en oeuvre verticalement : les cellules photovoltaïques 5 sont alors superposées les unes sur les autres (tel que cela est représenté sur la figure 10). En variante, l'empilement peut être réalisé de manière horizontale. Dans ce cas, les cellules photovoltaïques sont positionnées les unes à la suite des autres.

De manière avantageuse selon l'invention, comme cela est représenté sur la figure 10, chaque cellule photovoltaïque 5 est positionnée de sorte que d'une part, l'élément d'isolation extérieur 10A et l'élément d'isolation intérieur 10B d'une cellule photovoltaïque et, d'autre part, l'autre élément d'isolation extérieur 12A et de l'autre élément d'isolation intérieur 12B de la cellule photovoltaïque 5 adjacente sont placés entre cette cellule photovoltaïque 5 et la cellule photovoltaïque 5 adjacente. En d'autres termes, dans l'empilement 6, les cellules photovoltaïques 5 sont agencées les unes à la suite des autres avec le positionnement d'une part, d'un élément d'isolation extérieur 10A et d'un élément d'isolation intérieur 10B d'une cellule photovoltaïque et, d'autre part, d'un autre élément d'isolation extérieur 12A et d'un autre élément d'isolation intérieur 12B d'une cellule photovoltaïque adjacente entre deux cellules photovoltaïques 5 adjacentes.

Autrement dit encore, cet agencement est mis en oeuvre de telle façon que la face avant 5A de la cellule photovoltaïque 5A de la cellule photovoltaïque 5 munie de l'élément d'isolation extérieur 10A et de l'élément d'isolation intérieur 10B est positionnée à distance de la face arrière 5B de la cellule photovoltaïque 5 adjacente munie de l'autre élément d'isolation extérieur 12A et de l'autre élément d'isolation intérieur 12B.

Pour mémoire, les cellules photovoltaïques 5 considérées dans ce cinquième mode de réalisation présentent toutes la même configuration avec d'une part, un élément d'isolation extérieur 10A et un élément d'isolation intérieur 10B formés sur la face avant, et, d'autre part, d'un autre élément d'isolation extérieur 12A et d'un autre élément d'isolation intérieur 12B formés sur la face arrière 5B.

Les faces des cellules photovoltaïques 5 ne sont donc pas en contact entre elles lorsque qu'elles sont empilées. Cela permet notamment d'éviter de dégrader les éléments de métallisation, et donc les performances électriques des cellules photovoltaïque.

De manière avantageuse ici, et grâce à l'agencement de l'élément d'isolation extérieur 10A, de l'élément d'isolation intérieur 10B, de l'autre élément d'isolation extérieur 12A et de l'autre élément d'isolation intérieur 12B, l'empilement des cellules photovoltaïques 5 est mis en oeuvre de telle façon que l'autre élément d'isolation extérieur 12A est positionné entre l'élément d'isolation extérieur 10A et l'élément d'isolation intérieur 10B de la cellule photovoltaïque 5 adjacente. Cette configuration est visible sur la figure 10. D'après cet agencement, l'élément d'isolation intérieur 10B est positionné entre l'autre élément d'isolation extérieur 12A et l'autre élément d'isolation intérieur 12B.

En plus des avantages présentés pour le deuxième mode de réalisation, la configuration du cinquième mode de mise en oeuvre est particulièrement avantageuse car, grâce à l'agencement, en alternance et de manière juxtaposée, de l'élément d'isolation extérieur 10A, de l'élément d'isolation intérieur 10B, de l'autre élément d'isolation extérieur 12A et de l'autre élément d'isolation intérieur 12B, elle permet de renforcer l'effet de barrière à la pénétration des espèces de passivation utilisées pour le dépôt. L'élément d'isolation extérieur 10A, l'élément d'isolation intérieur 10B, l'autre élément d'isolation extérieur 12A et l'autre élément d'isolation intérieur 12B forment donc une quadruple barrière permettant d'isoler la face avant 5A et la face arrière 5B de chaque cellule photovoltaïque 5 de l'extérieur de l'empilement 6. Cela permet de s'assurer d'autant plus que seul le bord périphérique 5C des cellules photovoltaïques 5 est exposé aux espèces de passivation pour le dépôt de la couche de passivation (les autres parties des cellules photovoltaïques 5 étant isolées grâce à la présence de l'élément d'isolation extérieur 10A, de l'élément d'isolation intérieur 10B, de l'autre élément d'isolation extérieur 12A et de l'autre élément d'isolation intérieur 12B entre chaque cellule photovoltaïque 5, qui forment une quadruple barrière aux espèces de passivation utilisées).

Par ailleurs, le positionnement de l'élément d'isolation extérieur 10A, de l'élément d'isolation intérieur 10B, de l'autre élément d'isolation extérieur 12A et de l'autre élément d'isolation intérieur 12B, de manière successive et juxtaposée, permet de garantir un bon alignement des cellules photovoltaïques 5 lors de leur empilement (garantissant également la formation de la couche de passivation sur les bords périphériques 5C des cellules photovoltaïques 5 empilées).

La présente invention est décrite pour des sous-cellules mais peut également être mise en oeuvre avec des cellules photovoltaïques de pleine taille. En particulier, pour des technologies de cellules avancées telles que les cellules à hétérojonction (HET), il peut être utile d'améliorer la passivation existante des bords de cellule en formant une nouvelle couche de passivation.

## Revendications

1. Procédé de passivation de cellules photovoltaïques (5) comprenant des étapes de :
- fourniture d'une pluralité de cellules photovoltaïques (5), chaque cellule photovoltaïque (5) comprenant une face avant (5A), destinée à être exposée à un rayonnement incident, une face arrière (5B) opposée à la face avant (5A) et un bord périphérique (5C) reliant la face avant (5A) et la face arrière (5B),
- sur chaque cellule photovoltaïque (5) de la pluralité de cellules photovoltaïques, formation d'un premier élément d'isolation (10, 12 ; 10A, 10B ; 12A, 12B) conformé selon le pourtour de la cellule photovoltaïque (5) concernée, le premier élément d'isolation (10, 12 ; 10A, 10B ; 12A, 12B) étant formé sur la face avant (5A) ou sur la face arrière (5B) de la cellule photovoltaïque (5) concernée,
- empilement de la pluralité de cellules photovoltaïques (5), le premier élément d'isolation (10, 12 ; 10A, 10B ; 12A, 12B) de chaque cellule photovoltaïque (5) étant positionné entre la cellule photovoltaïque (5) concernée et une cellule photovoltaïque (5) adjacente de telle manière que la face (5A, 5B) de la cellule photovoltaïque (5) munie du premier élément d'isolation (10, 12 ; 10A, 10B ; 12A, 12B) soit positionnée à distance de la face (5B, 5A) en regard de la cellule photovoltaïque (10, 12 ; 10A, 10B ; 12A, 12B) adjacente, et
- dépôt d'une couche de passivation sur le bord périphérique (5C) des cellules photovoltaïques (5) de la pluralité de cellules photovoltaïques par injection d'au moins une espèce de passivation, le premier élément d'isolation (10, 12, 15 ; 10A, 10B ; 12A, 12B) formant une barrière de pénétration à l'espèce de passivation de sorte que la couche de passivation recouvre le bord périphérique (5C) de chaque cellule photovoltaïque (5).

2. Procédé de passivation selon la revendication 1, dans lequel, pour chaque cellule photovoltaïque (5) de la pluralité de cellules photovoltaïques, le premier élément d'isolation (10, 12, 10A, 12A) est formé, sur l'une de la face avant (5A) ou de la face arrière (5B), à une distance, du bord périphérique (5C), inférieure à 50 micromètres.

3. Procédé de passivation selon la revendication 1 ou 2, dans lequel le premier élément d'isolation (10, 12, 15 ; 10A, 10B ; 12A, 12B) présente une largeur inférieure à 100 micromètres.

4. Procédé de passivation selon l'une des revendications 1 à 3, dans lequel le premier élément d'isolation (10, 12, 15 ; 10A, 10B ; 12A, 12B) présente une largeur comprise entre 30 et 60 micromètres.

5. Procédé de passivation selon l'une quelconque des revendications 1 à 4, dans lequel, chaque cellule photovoltaïque (5) présentant, sur au moins l'une de la face avant (5A) et de la face arrière (5B), au moins un élément de métallisation (7, 8), le premier élément d'isolation (10, 12, 15 ; 10A, 10B ; 12A, 12B) présente une hauteur supérieure ou égale à la hauteur de l'élément de métallisation (7, 8).

6. Procédé de passivation selon l'une quelconque des revendications 1 à 5, dans lequel le premier élément d'isolation (10, 12, 15 ; 10A, 10B ; 12A, 12B) est formé d'un matériau métallique conducteur électriquement.

7. Procédé de passivation selon la revendication 6, dans lequel le premier élément d'isolation (10, 12, 15 ; 10A, 10B ; 12A, 12B) est formé par sérigraphie.

8. Procédé de passivation selon l'une quelconque des revendications 1 à 5, dans lequel le premier élément d'isolation (10, 12, 15 ; 10A, 10B ; 12A, 12B) est formé d'un matériau polymère.

9. Procédé de passivation selon l'une quelconque des revendications 1 à 8, dans lequel, lors de l'étape d'empilement, les cellules photovoltaïques (5) sont positionnées de telle manière que le premier élément d'isolation (10, 15 ; 10A, 10B, 12A, 12B) formé est en contact direct avec l'une des faces (5A, 5B) de la cellule photovoltaïque (5) adjacente.

10. Procédé de passivation selon l'une quelconque des revendications 1 à 9, dans lequel, pour chaque cellule photovoltaïque (5), il est prévu une étape de formation d'un deuxième élément d'isolation (15 ; 10A, 10B, 12A, 12B) le pourtour de la cellule photovoltaïque (5) concernée, le deuxième élément d'isolation (15 ; 10A, 10B, 12A, 12B) étant formé sur la même face (5A, 5B) que le premier élément d'isolation (10 ; 10A, 10B ; 12A, 12B), en parallèle du premier élément d'isolation (10 ; 10A, 10B ; 12A, 12B).

11. Procédé de passivation selon la revendication 10, dans lequel le deuxième élément d'isolation (15 ; 10B, 12B) est formé à une distance du premier élément d'isolation (10 ; 10A ; 12A) inférieure à 50 micromètres.

12. Procédé de passivation selon l'une quelconque des revendications 1 à 11, dans lequel, pour chaque cellule photovoltaïque (5), il est prévu une étape de formation d'un troisième élément d'isolation (10A, 10B ; 12A, 12B) conformé selon le pourtour de la cellule photovoltaïque (5) concernée, le troisième élément d'isolation (10A, 10B ; 12A, 12B) étant formé sur la face (5A, 5B) opposée à la face (5A, 5B) munie du premier élément d'isolation (10 ; 10A, 10B ; 12A, 12B).

13. Procédé de passivation selon la revendication 12 prise dans la dépendance de la revendication 10 ou 11, dans lequel, lors de l'étape d'empilement, les cellules photovoltaïques (5) sont positionnées de telle sorte que le troisième élément d'isolation (10 ; 10A, 10B ; 12A, 12B) d'une cellule photovoltaïque (5) est placé entre le premier élément d'isolation (10A, 10B ; 12A, 12B) et le deuxième élément d'isolation (10A, 10B ; 12A, 12B) de la cellule photovoltaïque (5) adjacente, le troisième élément d'isolation (10 ; 10A, 10B ; 12A, 12B) étant en contact direct avec la face (5A, 5B) de la cellule photovoltaïque (5) adjacente sur laquelle sont formés le premier élément d'isolation (10A, 10B ; 12A, 12B) et le deuxième élément d'isolation (10A, 10B ; 12A, 12B).

14. Procédé de passivation selon l'une quelconque des revendications 1 à 8, dans lequel, pour chaque cellule photovoltaïque (5), il est prévu une étape de formation d'un quatrième élément d'isolation (12) conformé selon le pourtour de la cellule photovoltaïque (5) concernée, le quatrième élément d'isolation (12) étant formé sur la face opposée (5B) à la face (5A) munie du premier élément d'isolation (10), le quatrième élément d'isolation (12) étant formé en regard du premier élément d'isolation (10).

15. Procédé de passivation selon la revendication 14, dans lequel, lors de l'étape d'empilement, les cellules photovoltaïques (5) sont positionnées de telle manière que le premier élément d'isolation (10) d'une cellule photovoltaïque (5) est en contact avec le quatrième élément d'isolation (12) de la cellule photovoltaïque (5) adjacente.
